# EUROPEAN PATENT APPLICATION

(11) **EP 4 769 484 A1**
(43) Date of publication of application: **01.07.2026**
(21) Application number: 24878855.6
(22) Date of filing: 30.09.2024
(51) Int. Cl.: H01L 21/311

(54) **ETCHING METHOD FOR SILICON-CONTAINING ORGANIC DIELECTRIC LAYER, AND SEMICONDUCTOR PROCESSING DEVICE**

(30) Priority: 16.10.2023 CN 202311337255
(71) Applicant: Beijing NAURA Microelectronics Equipment Co., Ltd., Beijing 100176 (CN)
(72) Inventor: ZHANG, Yue, Beijing 100176 (CN)
(74) Representative: Cohausz & Florack
(86) International application number: PCT/CN2024/122875
(87) International publication number: WO 2025/082211

(57) **Abstract**

The present disclosure provides an etching method for a silicon-containing organic dielectric layer, and a semiconductor processing equipment. At least two cyclically alternating etching steps are adopted to etch a silicon-containing organic dielectric layer, the at least two etching steps include a first etching step and a second etching step, an etching gas used in the first etching step at least includes an oxygen-containing gas, and an etching gas used in the second etching step at least includes the oxygen-containing gas and a fluorine-containing gas. Thus, by alternately and cyclically performing the first etching step and the second etching step, a gas flow ratio of the fluorine-containing gas to the oxygen-containing gas can be adjusted to further adjust etching rates of different elements in the silicon-containing organic dielectric layer, so that sub-trenches or bumps at a bottom of a trench or through hole in the silicon-containing organic dielectric layer can be reduced, and the bottom of the trench or through hole can have smooth morphology, which can avoid excessive concentration of electric field stress at the bottom of the trench or through hole and further avoid an influence of the excessive concentration of the electric field stress at the bottom of the trench or through hole on performance of an electronic device.

## Description

### TECHNICAL FIELD

The present disclosure relates to the field of semiconductor manufacturing technology, and in particular, to an etching method for a silicon-containing organic dielectric layer, and a semiconductor processing equipment.

### BACKGROUND

With the rapid development of integrated circuits, silicon-containing organic materials such as benzocyclobutene (BCB) are widely used as dielectric materials in electronic devices in various fields due to wide curing temperature range, low curing temperature, low dielectric constant, good adhesion performance, and good hydrophobicity. However, when a silicon-containing organic dielectric layer made of a silicon-containing organic material such as BCB is etched, sub-trench morphology or rough morphology can be easily caused at a bottom of an etched trench or through hole, which causes excessive concentration of electric field stress at the bottom of the trench or through hole, and further affects performance of an electronic device.

### SUMMARY

The present disclosure provides an etching method for a silicon-containing organic dielectric layer, and a semiconductor processing equipment, and aims to reduce sub-trenches or bumps at a bottom of an etched trench or through hole in a silicon-containing organic dielectric layer, so as to enable the bottom of the trench or through hole to have smooth morphology.

In a first aspect, the present disclosure provides an etching method for a silicon-containing organic dielectric layer, including: etching a silicon-containing organic dielectric layer with at least two cyclically alternating etching steps; wherein the at least two etching steps include a first etching step and a second etching step, an etching gas used in the first etching step at least includes an oxygen-containing gas, and an etching gas used in the second etching step at least includes the oxygen-containing gas and a fluorine-containing gas.

In some alternative examples, during cyclically alternating execution of the at least two etching steps, a ratio of fluorine to oxygen is greater than 0 and less than or equal to 15, or a content of fluorine is 0; or in the first etching step, a ratio of fluorine to oxygen is less than 0.01, or a content of fluorine is 0.

In some alternative examples, a gas flow range of the oxygen-containing gas in the first etching step is 5 sccm-200 sccm; and/or a gas flow range of the oxygen-containing gas in the second etching step is 5 sccm-200 sccm, and a gas flow range of the fluorine-containing gas in the second etching step is 5 sccm-20 sccm.

In some alternative examples, a material of the silicon-containing organic dielectric layer includes benzocyclobutene (BCB), the oxygen-containing gas includes at least one of O₂, CO₂, CO, or SO₂, and the fluorine-containing gas includes at least one of CF₄, C₄F₈, CHF₃, NF₃, SF₆, CH₂F₂, or C₂F₆.

In some alternative examples, the etching gas in the first etching step and the etching gas in the second etching step further include an inert gas; and the inert gas includes at least one of Ar, He, or Ne.

In some alternative examples, a gas flow range of the inert gas in the first etching step is 5 sccm-200 sccm; and a gas flow range of the inert gas in the second etching step is 5 sccm-200 sccm.

In some alternative examples, during cyclically alternating execution of the at least two etching steps, a ratio of fluorine to inert element is greater than 0 and less than or equal to 60, or a content of fluorine is 0; or
in the first etching step, a ratio of fluorine to inert element is less than 0.01, or a content of fluorine is 0.

In some alternative examples, during cyclically alternating execution of the at least two etching steps, a gas flow rate of the oxygen-containing gas is kept unchanged, a gas flow rate of the inert gas is kept unchanged, and a variation curve of a gas flow rate of the fluorine-containing gas exhibits a pulse waveform.

In some alternative examples, a process time range in the first etching step is 0.2 s-8 s, and/or a process time range in the second etching step is 0.2 s-5 s.

In some alternative examples, a chamber pressure range in the first etching step is 2 mTorr-30 mTorr; and/or a chamber pressure range in the second etching step is 2 mTorr-30 mTorr.

In some alternative examples, the at least two etching steps further include at least one third etching step, which is between the first etching step and the second etching step, and a flow rate of an etching gas used in the third etching step is less than a flow rate of the etching gas in the first etching step and a flow rate of the etching gas in the second etching step.

In a second aspect, the present disclosure provides a semiconductor processing equipment, including a process chamber, a gas inlet assembly, an upper electrode assembly, a lower electrode assembly, and a control device, the control device includes at least one storage device and at least one processor, the at least one storage device stores a computer program, and the at least one processor executes the computer program to implement the above etching method for a silicon-containing organic dielectric layer.

According to the etching method for a silicon-containing organic dielectric layer and the semiconductor processing equipment provided herein, the at least two cyclically alternating etching steps are adopted to etch the silicon-containing organic dielectric layer, the at least two etching steps include the first etching step and the second etching step, the etching gas in the first etching step at least includes the oxygen-containing gas, and the etching gas in the second etching step at least includes the oxygen-containing gas and the fluorine-containing gas. Thus, by alternately and cyclically performing the first etching step and the second etching step, the gas flow ratio of the fluorine-containing gas to the oxygen-containing gas can be adjusted to further adjust etching rates of different elements in the silicon-containing organic dielectric layer, so that sub-trenches or bumps at a bottom of a trench or through hole in the silicon-containing organic dielectric layer can be reduced, and the bottom of the trench or through hole can have smooth morphology, which can avoid excessive concentration of electric field stress at the bottom of the trench or through hole and further avoid an influence of the excessive concentration of the electric field stress at the bottom of the trench or through hole on performance of an electronic device.

### BRIEF DESCRIPTION OF DRAWINGS

In order to describe the technical solutions in the embodiments or the background part of the present disclosure more clearly, the drawings for the embodiments or the background part of the present disclosure will be described below.
FIG. 1 is a Scanning Electron Microscope (SEM) image of a trench in a silicon-containing organic dielectric layer which is etched with an existing etching method.
FIG. 2 to FIG. 8 are schematic cross-sectional views of an electronic device in each flow of an etching method for a silicon-containing organic dielectric layer according to an embodiment of the present disclosure.
FIG. 9 is an SEM image of a trench having rough morphology at a bottom thereof according to an embodiment of the present disclosure.
FIG. 10 is an SEM image of a trench having sub-trench morphology at a bottom thereof according to an embodiment of the present disclosure.
FIG. 11 is an SEM image of a trench etched with an etching method for a silicon-containing organic dielectric layer according to an embodiment of the present disclosure.
FIG. 12 is an SEM image of a trench having bowing morphology on a sidewall thereof according to an embodiment of the present disclosure.
FIG. 13 is a curve graph illustrating variations of gas flow rates of an oxygen-containing gas (e.g., O₂), a fluorine-containing gas (e.g., SF₆), and an inert gas (e.g., Ar) over time in an etching method for a silicon-containing organic dielectric layer according to an embodiment of the present disclosure.
FIG. 14 is a curve graph illustrating a variation of a flow ratio of a fluorine-containing gas (e.g., SF₆) to an inert gas (e.g., Ar) over time and a variation of a flow ratio of the fluorine-containing gas (e.g., SF₆) to an oxygen-containing gas (e.g., O₂) over time in an etching method for a silicon-containing organic dielectric layer according to an embodiment of the present disclosure.
FIG. 15 is a schematic structural diagram of a semiconductor processing equipment according to an embodiment of the present disclosure.

### DETAIL DESCRIPTION OF EMBODIMENTS

The technical solutions of the embodiments of the present disclosure will be clearly and thoroughly described below in conjunction with the drawings for the embodiments of the present disclosure. Apparently, the embodiments described herein are just some embodiments of the present disclosure, and do not cover all embodiments. All other embodiments derived by those of ordinary skill in the art from the embodiments described herein without any inventive work fall within the scope of the present disclosure.

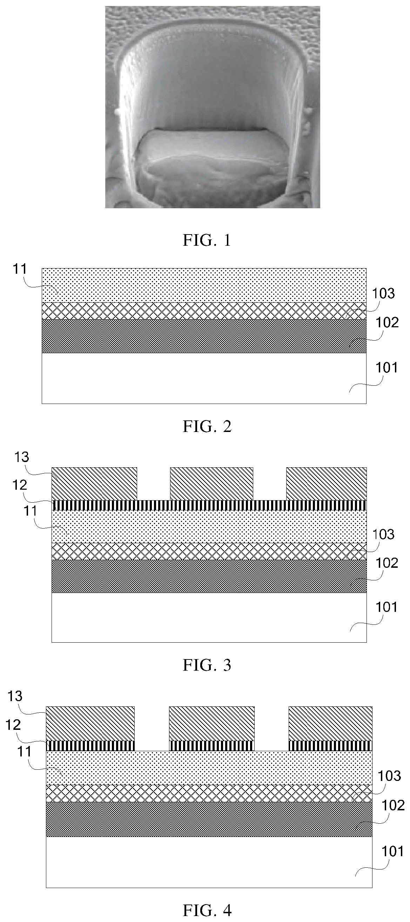

As shown in FIG. 1, when an existing etching method is adopted to etch a silicon-containing organic dielectric layer made of a silicon-containing organic material such as BCB, sub-trench morphology or rough morphology can be easily caused at a bottom of an etched trench or through hole, which causes excessive concentration of electric field stress at the bottom of the trench or through hole, and further affects performance of an electronic device.

It has been found by research that an imbalance in etching rates of different elements in the silicon-containing organic dielectric layer is a main cause of the sub-trench morphology or the rough morphology. For example, if an etching rate of Si in the silicon-containing organic dielectric layer is higher than that of C-H in the silicon-containing organic dielectric layer, the rough morphology at the bottom of the silicon-containing organic dielectric layer is caused; and if the etching rate of Si is lower than that of C-H, the sub-trench morphology at the bottom of the silicon-containing organic dielectric layer is caused.

In view of the above, the present disclosure provides an etching method for a silicon-containing organic dielectric layer, including:
etching a silicon-containing organic dielectric layer with at least two cyclically alternating etching steps, with an etching gas used in at least one of the at least two cyclically alternating etching steps including an oxygen-containing gas, and an etching gas used in at least one of the at least two cyclically alternating etching steps including the oxygen-containing gas and a fluorine-containing gas, so as to enable a bottom of a trench or through hole in the silicon-containing organic dielectric layer to have smooth morphology.

As an alternative implementation of the present disclosure, an embodiment of the present disclosure provides an etching method for a silicon-containing organic dielectric layer, including:
etching a silicon-containing organic dielectric layer with at least two cyclically alternating etching steps, with the at least two etching steps including a first etching step and a second etching step, an etching gas used in the first etching step at least including an oxygen-containing gas, and an etching gas used in the second etching step at least including the oxygen-containing gas and a fluorine-containing gas.

In the embodiments of the present disclosure, an electronic device manufactured from the silicon-containing organic dielectric layer may be used in the fields of wireless communication base stations, satellite navigation, mobile communication and the like, and the electronic device may be a power amplifier, a rectifier, an oscillator, a phase-locked loop, a controller, or a storage device.

As shown in FIG. 2, the electronic device may include, for example, a substrate 101 and a silicon-containing organic dielectric layer 11 located on a side of the substrate 101. In some alternative implementations, a metal layer 102 and an isolation layer 103 may be further disposed between the substrate 101 and the silicon-containing organic dielectric layer 11.

The substrate 101 may include, for example, a gallium arsenide (GaAs) substrate, a silicon substrate, a germanium substrate, or a silicon germanium substrate, the metal layer 102 may include, for example, an Au layer, the isolation layer 103 may include, for example, a silicon nitride layer, and a material of the silicon-containing organic dielectric layer 11 includes BCB.

In some embodiments of the present disclosure, when the silicon-containing organic dielectric layer 11 is etched, as shown in FIG. 3, firstly, an anti-reflection layer 12 and a patterned photoresist layer 13 are sequentially formed on a surface of the silicon-containing organic dielectric layer 11 away from the substrate 101; and a material of the anti-reflection layer 12 may be, for example, silicon nitride or silicon oxynitride. An entire photoresist layer may be exposed with a mask having a preset mask pattern to transfer the mask pattern to the photoresist layer, and then the photoresist layer is developed to form the patterned photoresist layer 13.

Then, as shown in FIG. 4, the anti-reflection layer 12 is etched by using the patterned photoresist layer 13 as a mask, so as to transfer the mask pattern to the anti-reflection layer 12. The anti-reflection layer 12 can alleviate or eliminate a standing wave effect of the photoresist layer 13, and improve accuracy of transfer of the mask pattern from the mask to the photoresist layer. Certainly, in some embodiments of the present disclosure, the anti-reflection layer 12 may not be provided, which is not described here.

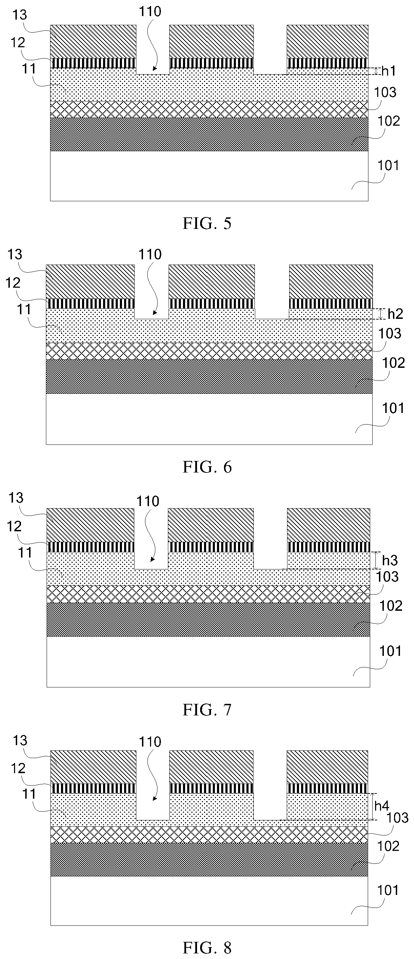

Then, as shown in FIG. 5, taking the patterned photoresist layer 13 as a mask, the first etching step is performed to etch the silicon-containing organic dielectric layer 11 to form a trench 110 with a depth equal to a first preset depth h1. Then, as shown in FIG. 6, the second etching step is performed to etch the silicon-containing organic dielectric layer 11 to make the depth of the trench 110 equal to a second preset depth h2, which is greater than h1. Then, as shown in FIG. 7, the first etching step is performed to etch the silicon-containing organic dielectric layer 11 to make the depth of the trench 110 equal to a third preset depth h3, which is greater than h2. Then, as shown in FIG. 8, the second etching step is performed to etch the silicon-containing organic dielectric layer 11 to make the depth of the trench 110 equal to a fourth preset depth h4, which is greater than h3, and so on until the depth of the trench 110 is equal to a desired depth, thereby forming a desired trench or through hole. It should be noted that in the embodiments of the present disclosure, each of the at least two etching steps for etching the silicon-containing organic dielectric layer 11 adopts a dry etching process, such as a plasma etching process.

In some embodiments, the anti-reflection layer 12 may be etched first, and then the silicon-containing organic dielectric layer 11 is etched with the first etching step. Certainly, the present disclosure is not limited thereto. In some other embodiments, the anti-reflection layer 12 may be etched while etching the silicon-containing organic dielectric layer 11 with the first etching step, which is not described here.

In some embodiments of the present disclosure, the first etching step may be performed first to etch the silicon-containing organic dielectric layer 11, and then the second etching step is performed to etch the silicon-containing organic dielectric layer 11. However, the present disclosure is not limited thereto. In some other embodiments, the second etching step may be performed first to etch the silicon-containing organic dielectric layer 11, and then the first etching step is performed to etch the silicon-containing organic dielectric layer 11, which is not described here.

In some embodiments of the present disclosure, the oxygen-containing gas includes at least one of O₂, CO₂, CO, or SO₂, and the fluorine-containing gas includes at least one of CF₄, C₄F₈, CHF₃, NF₃, SF₆, CH₂F₂, or C₂F₆. Further, in some embodiments, the oxygen-containing gas includes O₂, and the fluorine-containing gas includes SF₆. On this basis, in some embodiments, the etching gas in the first etching step includes O₂, and the etching gas in the second etching step includes O₂ and SF₆.

The etching gas in the first etching step at least includes the oxygen-containing gas (e.g., O₂), and is substantially free of fluorine, and a flow ratio of fluorine to oxygen is less than 0.01, or a content of fluorine is 0; the etching gas in the second etching step at least includes the oxygen-containing gas (e.g., O₂) and the fluorine-containing gas (e.g., SF₆); and the first etching step and the second etching step are performed alternately and cyclically. Therefore, by alternately and cyclically performing the first etching step and the second etching step, for example, by intermittently introducing the fluorine-containing gas, a gas flow ratio of the fluorine-containing gas to the oxygen-containing gas in a process chamber may be adjusted to further adjust a ratio of fluorine to oxygen in the process chamber, so that etching rates of different elements in the silicon-containing organic dielectric layer 11 may be adjusted, which may further reduce sub-trenches or bumps at a bottom of a trench or through hole formed by etching the silicon-containing organic dielectric layer 11. Thus, the bottom of the trench or through hole can have smooth morphology, so that excessive concentration of electric field stress at the bottom of the trench or through hole can be avoided, and an influence of the excessive concentration of the electric field stress at the bottom of the trench or through hole on performance of an electronic device can be avoided.

In some embodiments of the present disclosure, during cyclically alternating execution of the at least two etching steps, the ratio of fluorine to oxygen in the process chamber is greater than 0 and less than or equal to 15, or a content of fluorine in the process chamber is 0, so as to enable the bottom of the trench or through hole to have smooth morphology. It should be understood that in some embodiments, since the etching gas in the first etching step does not include a fluorine-containing gas, that is, the content of fluorine is 0, a ratio of fluorine to oxygen is 0 when the first etching step is performed during the cyclically alternating execution of the at least two etching steps; and in some other embodiments, the etching gas in the first etching step may further include a small amount of fluorine-containing gas, for example, the ratio of fluorine to oxygen is less than 0.01. In some embodiments, for making the ratio of fluorine to oxygen greater than 0 and equal to or less than 15 or making the content of fluorine be 0, a gas flow ratio of SF₆ to O₂ is greater than 0 and equal to or less than 5 or a gas flow rate of SF₆ is 0. Certainly, the present disclosure is not limited thereto. In practical applications, a range of the flow ratio of the fluorine-containing gas to the oxygen-containing gas may be adjusted based on composition of the fluorine-containing gas and composition of the oxygen-containing gas, which will not be described here.

It should be understood that in some embodiments, the etching gas in the first etching step does not include a fluorine-containing gas (e.g., SF₆), or in other words, a gas flow rate of a fluorine-containing gas (e.g., SF₆) in the first etching step is 0. However, the present disclosure is not limited thereto. In some other embodiments, the etching gas in the first etching step may further include a fluorine-containing gas (e.g., SF₆), but it needs to be ensured that a gas flow rate of the fluorine-containing gas (e.g., SF₆) in the etching gas in the first etching step is less than a gas flow rate of the fluorine-containing gas (e.g., SF₆) in the etching gas in the second etching step, or it just needs to be ensured that the ratio of fluorine to oxygen in the process chamber is greater than 0 and less than or equal to 15 or the content of fluorine in the process chamber is 0 during the cyclically alternating execution of the at least two etching steps.

A principle of adjustment to etching rates of different elements in the silicon-containing organic dielectric layer 11 is described below by taking BCB as an example. A molecular formula of BCB is C₄H₁₂OSi₂, and an etching process of BCB includes etching of C-H and etching of Si. F ions and F-containing radicals dissociated from a fluorine-containing gas (e.g., SF₆) in a high-frequency electromagnetic field etch Si and produce gaseous SiFₓ, and the F ions and the F-containing radicals etch C-H and produce gaseous CFₓ and HFₓ. O ions and O-containing radicals dissociated from an oxygen-containing gas (e.g., O₂) etch Si and produce a deposit of SiOₓ, which is difficult to volatilize and thus hinders the etching of Si, and the O ions and the O-containing radicals etch C-H and produce volatile gaseous CO, CO₂ and H-O. That is, an etching rate of Si by the oxygen-containing gas (e.g., O₂) is lower than an etching rate of Si by the fluorine-containing gas (e.g., SF₆).

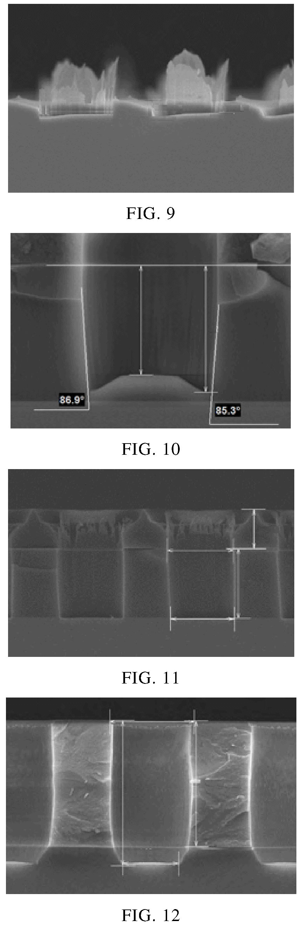

It can be seen from the molecular formula of BCB that a content of Si in BCB is smaller while a content of C-H is larger; and a generation rate of SiFₓ is higher than a generation rate of CFₓ and a generation rate of HFₓ. Therefore, if only the fluorine-containing gas such as SF₆ is used to etch BCB, or if the gas flow ratio of the fluorine-containing gas (e.g., SF₆) to the oxygen-containing gas (e.g., O₂) is greater than 5, the etching rate of Si is higher than that of C-H, such that an etching rate of BCB is greatly reduced, and the rough morphology shown in FIG. 9 is caused at a bottom of a trench or through hole of BCB, which causes excessive concentration of electric field stress at the bottom of the trench or through hole and further affects performance of an electronic device.

If only the oxygen-containing gas (e.g., O₂) is used to etch BCB, or if the gas flow ratio of the fluorine-containing gas (e.g., SF₆) to the oxygen-containing gas (e.g., O₂) is greater than and close to 0, or if the gas flow rate of the fluorine-containing gas (e.g., SF₆) is 0, the etching rate of the Si is lower than that of C-H, such that the sub-trench morphology shown in FIG. 10 is caused at the bottom of the trench or through hole of BCB, which causes the excessive concentration of the electric field stress at the bottom of the trench or through hole and further affects the performance of the electronic device.

In a case where the first etching step and the second etching step performed alternately and cyclically to etch BCB, by alternately and cyclically performing the first etching step and the second etching step, for example, by intermittently introducing the fluorine-containing gas (e.g., SF₆), the gas flow ratio of the fluorine-containing gas (e.g., SF₆) to the oxygen-containing gas (e.g., O₂) in the process chamber can be adjusted, for example, the flow ratio of SF₆ to O₂ is adjusted to be greater than 0 and less than or equal to 15, or the gas flow rate of SF₆ is adjusted to 0, so that the ratio of fluorine to oxygen can be adjusted to balance the etching rate of Si and the etching rate of C-H. With the balance of the etching rate of Si and the etching rate of C-H, a requirement for the etching rate of BCB can be met, and the bottom of the trench or through hole of BCB can have the smooth morphology shown in FIG. 11, so that the excessive concentration of the electric field stress at the bottom of the trench or through hole can be avoided, and the influence on the performance of the electronic device can be further avoided.

In other words, the etching rate of Si by oxygen is different from that of Si by fluorine, and the etching rate of C-H by oxygen is also different from that of C-H by fluorine. For example, the etching rate of Si by fluorine is higher than that of Si by oxygen, and the etching rate of C-H by fluorine is lower than that of C-H by oxygen; on this basis, by intermittently introducing the fluorine-containing gas (e.g., SF₆) to adjust the gas flow ratio of the fluorine-containing gas (e.g., SF₆) to the oxygen-containing gas (e.g., O₂) in the process chamber, the flow ratio of fluorine to oxygen can be adjusted, so that the etching rate of Si and the etching rate of C-H can be adjusted to be balanced.

Certainly, in some embodiments, for adjusting the gas flow ratio of the fluorine-containing gas (e.g., SF₆) to the oxygen-containing gas (e.g., O₂) in the process chamber or for adjusting the flow ratio of fluorine to oxygen in the process chamber, a gas flow rate and/or a process time in the first etching step and/or the second etching step may be adjusted.

It should be noted that the etching rate of Si and the etching rate of C-H may also be adjusted by adjusting a gas flow ratio of the fluorine-containing gas (e.g., SF₆) to the oxygen-containing gas (e.g., O₂) in the second etching step when the second etching step is performed to etch BCB, but the bowing morphology shown in FIG. 12 may be caused on a sidewall of the trench or through hole, resulting in a risk of cross-linking or short-circuiting between adjacent trenches or through holes. By adopting the first etching step and the second etching step performed alternately and cyclically, the F ions and the F-containing radicals can be effectively prevented from always existing in the process chamber, so that the bowing morphology of the sidewall of the trench or through hole can be avoided.

In some embodiments of the present disclosure, a gas flow range of the oxygen-containing gas (e.g., O₂) in the first etching step is 5 sccm-200 sccm; and/or a gas flow range of the oxygen-containing gas (e.g., O₂) in the second etching step is 5 sccm-200 sccm, and a gas flow range of the fluorine-containing gas (e.g., SF₆) in the second etching step is 5 sccm-20 sccm.

In some embodiments of the present disclosure, a process time range in the first etching step is 0.2 s-8 s, and/or a process time range in the second etching step is 0.2 s-5 s. On this basis, the etching gases can be easily controlled, and the bottom of the trench or through hole in the silicon-containing organic dielectric layer can easily have smooth morphology.

It should be noted that if a process time in the first etching step and that in the second etching step are less than 0.2 s, which is a minimum time for effective gas intake control, gas control is not facilitated; if the process time in the second etching step is greater than 5 s, the flow ratio of SF₆ to O₂ is greater than 5, which causes rough morphology at the bottom of the trench or through hole of BCB; and if the process time in the first etching step is greater than 8 s, the flow ratio of SF₆ to O₂ is greater than and close to 0 or the gas flow rate of SF₆ is 0, which causes the sub-trench morphology at the bottom of the trench or through hole of BCB.

In some embodiments of the present disclosure, a chamber pressure range in the first etching step is 2 mTorr-30 mTorr, and/or a chamber pressure range in the second etching step is 2 mTorr-30 mTorr. On this basis, a chamber pressure can be prevented from being too high or too low to affect an etching effect of the silicon-containing organic dielectric layer. In some embodiments, a chamber pressure in the first etching step is the same as that in the second etching step.

In some embodiments of the present disclosure, an upper radio frequency (RF) power range in the first etching step is 300 W-2500 W, and a lower RF power range in the first etching step is 100 W-1200 W; and/or an upper RF power range in the second etching step is 300 W-2500 W, and a lower RF power range in the second etching step is 100 W-1200 W. In some embodiments, an upper RF power in the first etching step is the same as that in the second etching step, and a lower RF power in the first etching step is the same as that in the second etching step.

In some examples, in the first etching step, a gas flow rate of the oxygen-containing gas (e.g., O₂) is 32 sccm, the process time is 3 s, the chamber pressure is 4 mTorr, the upper RF power is 300 W, and the lower RF power is 100 W. In the second etching step, a gas flow rate of the oxygen-containing gas (e.g., O₂) is 32 sccm, the gas flow rate of the fluorine-containing gas (e.g., SF₆) is 8 sccm, the process time is 2 s, the chamber pressure is 4 mTorr, the upper RF power is 300 W, and the lower RF power is 100 W.

In some embodiments of the present disclosure, the etching gas in the first etching step and that in the second etching step further include an inert gas, which includes at least one of Ar, He, or Ne. In some embodiments, the etching gas in the first etching step and that in the second etching step further include Ar, in which case the etching gas in the first etching step includes Ar and O₂, and the etching gas in the second etching step includes Ar, O₂, and SF₆.

Since Ar radicals and Ar ions dissociated from Ar in a high-frequency electromagnetic field play a physical bombardment role and do not participate in any chemical reaction, the Ar radicals and the Ar ions can not only remove a polymer which is generated in the etching processes, but also improve verticality of the sidewall of the etched trench or through hole, so as to avoid cross-linking of adjacent through holes caused by low verticality, and also avoid short-circuiting of signals transmitted in a conductor in the trench or through hole caused by low verticality.

In some embodiments of the present disclosure, in the first etching step, the gas flow range of the oxygen-containing gas (e.g., O₂) is 5 sccm-200 sccm, a gas flow range of the inert gas (e.g., Ar) is 5 sccm-200 sccm, the process time range is 0.2 s-8 s, the chamber pressure range is 2 mTorr-30 mTorr, the upper RF power range is 300 W-2500 W, and the lower RF power range is 100 W-1200 W. In the second etching step, the gas flow range of the oxygen-containing gas (e.g., O₂) is 5 sccm-200 sccm, the gas flow range of the fluorine-containing gas (e.g., SF₆) is 5 sccm-20 sccm, a gas flow range of the inert gas (e.g., Ar) is 5 sccm-200 sccm, the process time range is 0.2 s-5 s, the chamber pressure range is 2 mTorr-30 mTorr, the upper RF power range is 300 W-2500 W, and the lower RF power range is 100 W-1200 W.

In some examples, in the first etching step, the gas flow rate of the oxygen-containing gas (e.g., O₂) is 32 sccm, the gas flow rate of the inert gas (e.g., Ar) is 10 sccm, the process time is 3 s, the chamber pressure is 4 mTorr, the upper RF power is 300 W, and the lower RF power is 100 W. In the second etching step, the gas flow rate of the oxygen-containing gas (e.g., O₂) is 32 sccm, the gas flow rate of the fluorine-containing gas (e.g., SF₆) is 8 sccm, the gas flow rate of the inert gas (e.g., Ar) is 10 sccm, the process time is 2 s, the chamber pressure is 4 mTorr, the upper RF power is 300 W, and the lower RF power is 100 W.

In some embodiments, during the cyclically alternating execution of the at least two etching steps, a ratio of fluorine to inert element in the process chamber is greater than 0 and less than or equal to 60, or the content of fluorine in the process chamber is 0, so as to enable the bottom of the trench or through hole to have smooth rounded morphology. Also, since the etching gas in the first etching step does not include a fluorine-containing gas or the content of fluorine in the first etching step is extremely low, that is, a ratio of fluorine to inert element is less than 0.01 or the content of fluorine is 0, the ratio of fluorine to inert element is greater than 0 and less than or equal to 0.01 or the content of fluorine is 0 when the first etching step is performed during the cyclically alternating execution of the at least two etching steps. In some embodiments, a flow ratio of the fluorine-containing gas (e.g., SF₆) to the inert gas (e.g., Ar) is greater than 0 and less than or equal to 10 or the gas flow rate of the fluorine-containing gas (e.g., SF₆) is 0, so as to make the ratio of fluorine to inert element be greater than 0 and less than or equal to 60 or make the content of fluorine be 0.

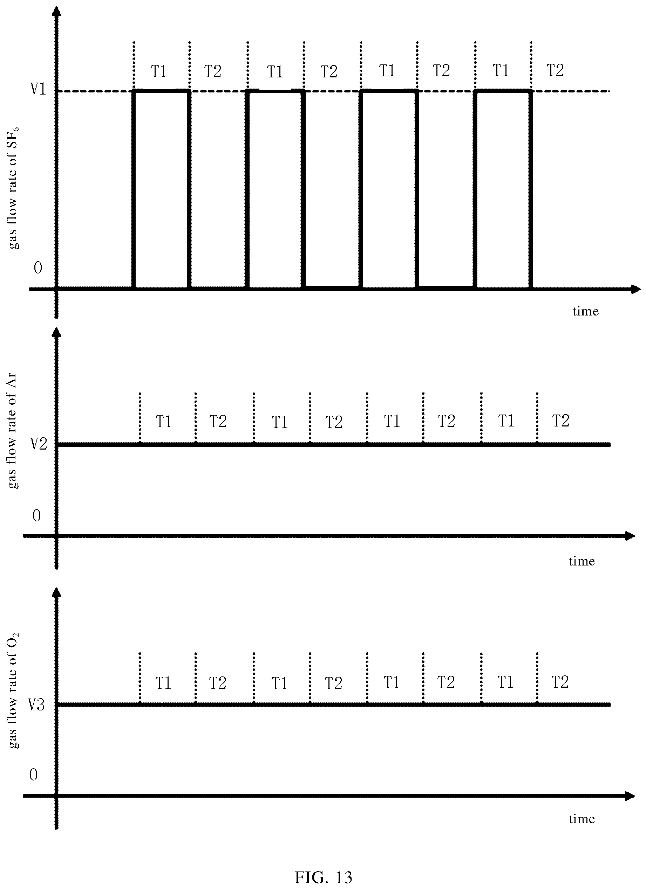

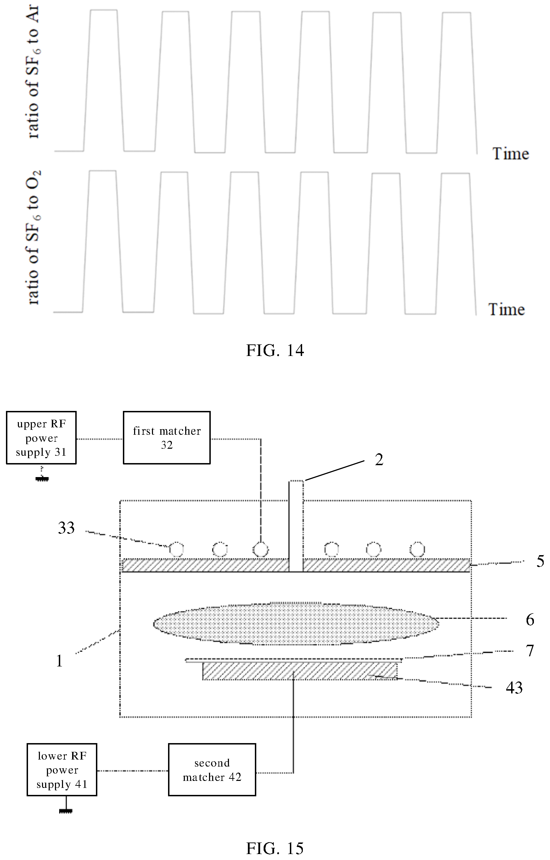

FIG. 13 shows a curve illustrating variations of the gas flow rates of the oxygen-containing gas (e.g., O₂), the fluorine-containing gas (e.g., SF₆), and the inert gas (e.g., Ar) over time during the cyclically alternating execution of the at least two etching steps, where V1 is the gas flow rate of SF₆, V₂ is the gas flow rate of Ar, V₃ is the gas flow rate of O₂, T1 is the process time in the second etching step, and T₂ is the process time in the first etching step. FIG. 14 shows a curve graph illustrating a variation of the flow ratio of the fluorine-containing gas (e.g., SF₆) to the inert gas (e.g., Ar) over time and a variation of the flow ratio of the fluorine-containing gas (e.g., SF₆) to the oxygen-containing gas (e.g., O₂) over time during the cyclically alternating execution of the at least two etching steps. During the cyclically alternating execution of the at least two etching steps, the gas flow rate of the oxygen-containing gas (e.g., O₂) is kept unchanged, the gas flow rate of the inert gas (e.g., Ar) is kept unchanged, and a variation curve of the gas flow rate of the fluorine-containing gas (e.g., SF₆) exhibits a pulse waveform.

Since the gases in the process chamber also need a certain period of time to be used up after the gas introduction into the process chamber is stopped, the flow ratio of the fluorine-containing gas (e.g., SF₆) to the inert gas (e.g., Ar) and the flow ratio of the fluorine-containing gas (e.g., SF₆) to the oxygen-containing gas (e.g., O₂) dynamically change, a slope of a variation curve of the flow ratio of the fluorine-containing gas (e.g., SF₆) to the inert gas (e.g., Ar) over time is greater than 0 and less than or equal to 10, or the gas flow rate of the fluorine-containing gas (e.g., SF₆) does not change, a slope of a variation curve of the flow ratio of the fluorine-containing gas (e.g., SF₆) to the oxygen-containing gas (e.g., O₂) over time is greater than 0 and less than or equal to 5, or the gas flow rate of the fluorine-containing gas (e.g., SF₆) does not change.

In some embodiments, the at least two etching steps only include the first etching step and the second etching step, that is, only the first etching step and the second etching step performed alternately and cyclically are adopted to etch the silicon-containing organic dielectric layer 11. However, the present disclosure is not limited thereto. In some other embodiments, the at least two etching steps may further include at least one third etching step, which is between the first etching step and the second etching step or between the second etching step and the first etching step, and a flow rate of an etching gas used in the third etching step is less than the flow rates of the etching gases in the first and second etching steps. The flow rate of the etching gas in the third etching step may be 0, that is, no gas is introduced into the process chamber in the third etching step, or a vacuum evacuation process is performed in the process chamber in the third etching step.

As another alternative implementation of the present disclosure, an embodiment of the present disclosure further provides a semiconductor processing equipment, which includes, but is not limited to, an inductively coupled plasma etching equipment or a capacitively coupled plasma etching equipment.

In some alternative embodiments, as shown in FIG. 15, taking the inductively coupled plasma etching equipment as an example, the semiconductor processing equipment includes a process chamber 1, a gas inlet assembly 2, a gas exhaust assembly (not shown), an upper electrode assembly, a lower electrode assembly, and a control device (not shown).

The gas inlet assembly 2 is configured to introduce a gas into the process chamber 1, and the gas includes a process gas. The control device is configured to control on and off of an electronic valve of the gas inlet assembly 2, so as to control the gas inlet assembly 2 to start or stop introducing the gas into the process chamber 1.

The gas exhaust assembly is used to discharge a gas out of the process chamber 1, and the gas includes a by-product gas generated after an etching reaction. The control device may be further configured to control on and off of an electronic valve of the gas exhaust assembly, so as to control the gas exhaust assembly to start or stop discharging the gas out of the process chamber 1. Further, the control device may be further configured to control opening of the electronic valve of the gas inlet assembly 2 and opening of the electronic valve of the gas exhaust assembly, so as to control a chamber pressure in the process chamber 1.

The upper electrode assembly includes an upper RF power supply 31, a first matcher 32 electrically connected to the upper RF power supply 31, and an RF coil 33 electrically connected to the first matcher 32. The upper RF power supply 31 may be electrically connected to the RF coil 33 in the process chamber 1 through the first matcher 32 to apply RF power to the RF coil 33, so that the RF coil 33 may couple the RF power to the process chamber 1 through a dielectric window 5 to ionize the gas in the process chamber 1 into plasma 6. The control device may be further configured to control the magnitude of the RF power applied to the RF coil 33 by the upper RF power supply 31 through the first matcher 32.

The lower electrode assembly includes a lower RF power supply 41, a second matcher 42 electrically connected to the lower RF power supply 41, and a carrier 43 electrically connected to the second matcher 42, and the carrier 43 includes an electrostatic chuck. The lower RF power supply 41 is electrically connected to the carrier 43 through the second matcher 42 to apply bias power to the carrier 43 to accelerate the plasma. The carrier 43 is configured to bear a to-be-processed device 7 and heat or cool the to-be-processed device 7.

All the technical features in the above embodiments can be arbitrarily combined, but not all possible combinations of the technical features in the above embodiments are described for conciseness of the description. However, any combination of the technical features should be considered to fall within the scope of the present disclosure as long as there is no contradiction in the combination of the technical features.

The above embodiments only illustrate several implementations of the present description, and those implementations are described in a specific and detailed manner, but those implementations should not be regarded as any limitation to the scope of the present disclosure. It should be noted that several variations and modifications can be made by those of ordinary skill in the art without departing from the concept of the present description, and all those variations and modifications fall within the scope of the present description. Therefore, the scope of the present disclosure shall be subject to the appended claims.

## Claims

1. An etching method for a silicon-containing organic dielectric layer, comprising:
etching a silicon-containing organic dielectric layer with at least two cyclically alternating etching steps; wherein the at least two etching steps comprise a first etching step and a second etching step, an etching gas used in the first etching step at least comprises an oxygen-containing gas, and an etching gas used in the second etching step at least comprises the oxygen-containing gas and a fluorine-containing gas.

2. The etching method of claim 1, wherein during cyclically alternating execution of the at least two etching steps, a ratio of fluorine to oxygen is greater than 0 and less than or equal to 15, or a content of fluorine is 0; or
in the first etching step, a ratio of fluorine to oxygen is less than 0.01, or a content of fluorine is 0.

3. The etching method of claim 1 or 2, wherein a gas flow range of the oxygen-containing gas in the first etching step is from 5 sccm to 200 sccm; and
a gas flow range of the oxygen-containing gas in the second etching step is from 5 sccm to 200 sccm, and a gas flow range of the fluorine-containing gas in the second etching step is from 5 sccm to 20 sccm.

4. The etching method of claim 1, wherein a material of the silicon-containing organic dielectric layer comprises benzocyclobutene (BCB), the oxygen-containing gas comprises at least one of O₂, CO₂, CO, or SO₂, and the fluorine-containing gas comprises at least one of CF₄, C₄F₈, CHF₃, NF₃, SF₆, CH₂F₂, or C₂F₆.

5. The etching method of claim 1, wherein the etching gas in the first etching step and the etching gas in the second etching step further comprise an inert gas; and the inert gas comprises at least one of Ar, He, or Ne.

6. The etching method of claim 5, wherein a gas flow range of the inert gas in the first etching step is from 5 sccm to 200 sccm; and a gas flow range of the inert gas in the second etching step is from 5 sccm to 200 sccm.

7. The etching method of claim 5, wherein during cyclically alternating execution of the at least two etching steps, a ratio of fluorine to inert element is greater than 0 and less than or equal to 60, or a content of fluorine is 0; or
in the first etching step, a ratio of fluorine to inert element is less than 0.01, or a content of fluorine is 0.

8. The etching method of claim 5, wherein during cyclically alternating execution of the at least two etching steps, a gas flow rate of the oxygen-containing gas is kept unchanged, a gas flow rate of the inert gas is kept unchanged, and a variation curve of a gas flow rate of the fluorine-containing gas exhibits a pulse waveform.

9. The etching method of claim 1, wherein a process time range in the first etching step is from 0.2 s to 8 s, and/or
a process time range in the second etching step is from 0.2 s to 5 s.

10. The etching method of claim 1, wherein a chamber pressure range in the first etching step is from 2 mTorr to 30 mTorr; and/or
a chamber pressure range in the second etching step is from 2 mTorr to 30 mTorr.

11. The etching method of claim 1, wherein the at least two etching steps further comprise at least one third etching step, which is between the first etching step and the second etching step, and a flow rate of an etching gas used in the third etching step is less than a flow rate of the etching gas in the first etching step and a flow rate of the etching gas in the second etching step.

12. A semiconductor processing equipment, comprising a process chamber, a gas inlet assembly, an upper electrode assembly, a lower electrode assembly, and a control device, wherein the control device comprises at least one storage device and at least one processor, the at least one storage device stores a computer program, and the at least one processor executes the computer program to implement the etching method for a silicon-containing organic dielectric layer of any one of claims 1 to 11.
